# EUROPEAN PATENT SPECIFICATION

(11) **EP 3 311 388 B1**
(45) Date of publication and mention of the grant of the patent: **17.04.2019**
(21) Application number: 16729890.0
(22) Date of filing: 15.06.2016
(51) Int. Cl.: H01B 1/22, H01L 31/00, H05K 1/00, H05K 3/00

(54) **CONDUCTIVE PASTE COMPRISING LUBRICATING OILS AND SEMICONDUCTOR DEVICE**
LEITFÄHIGE PASTE MIT SCHMIERÖLEN UND HALBLEITERBAUELEMENT
PÂTE CONDUCTRICE COMPRENANT DES HUILES DE LUBRIFICATION ET DISPOSITIF SEMI-CONDUCTEUR

(30) Priority: 17.06.2015 EP 15172602
(43) Date of publication of application: 25.04.2018
(73) Proprietor: BASF SE, 67056 Ludwigshafen am Rhein (DE)
(72) Inventor: GAO, Xuerong, Livingston, NJ 07039 (US); CSIHONY, Szilard, 69517 Gorxheimertal (DE); FIESS, Markus, 68163 Mannheim (DE); CZINK, Marco, 69124 Heidelberg (DE)
(74) Representative: BASF IP Association
(86) International application number: PCT/EP2016/063717
(87) International publication number: WO 2016/202841

(56) References cited:
- JP-A- 2003 151 350
- US-A1- 2013 126 797
- US-A1- 2014 124 713

## Description

The invention relates to a conductive paste comprising from 50 to 97 wt% of electrically conductive particles, 3 to 50 wt% of an organic medium and 0 to 20 wt% of a glass frit, the organic medium comprising a solvent.

Conductive pastes or inks can be used to form electrodes, such as conductive grid lines, for example silver grid lines, and bus bars on the surface of semiconductor substrates or substrates from an insulating material. A particularly preferred use is screen printing of electrodes on semiconductor substrates for the production of solar cells or photovoltaic cells which convert solar energy to electrical energy when photons from sunlight excite electrons on semiconductors from the valance band to the conduction band. The electrons which flow to the conduction band are collected by the metal electrodes that contact the semiconductors.

Besides for printing electrodes on semiconductor substrates for producing solar cells or photovoltaic cells, conductive pastes or inks can be used for printing grid lines on insulating substrates for producing printed electronic circuit boards or hybrid circuits on ceramic substrates.

To print fine lines onto either a semiconductor substrate or an insulating substrate, generally screen printing processes are used for cost efficient mass production. Nevertheless, to generate uniform narrow lines without line interruptions is challenging for screen printing, particularly for high speed screen printing. The industrial printing speed depends on the application requirement. It ranges from 80 mm/s to 800 mm/s, preferably not slower than 150 mm/s, for example in solar cell printing, the printing speed is 150 mm/s to 300 mm/s.

When the conductive paste is used for printing on semiconductor substrates, the paste usually comprises electrically conductive particles, which typically are metal powders, an organic medium and optionally a glass frit. The organic medium typically comprises at least one organic liquid, such as organic solvents or organic salts or other organic compounds having liquid form at room temperature. The organic medium comprises optionally a polymeric component. To form the metal contacts, the conductive paste is printed onto a substrate. Depending on the type of materials, the substrate is then heated at a temperature in the range from about 150 °C to about 950 °C, where the organic medium is decomposed and the inorganic species form the conductive tracks and electrical contact to the substrate.

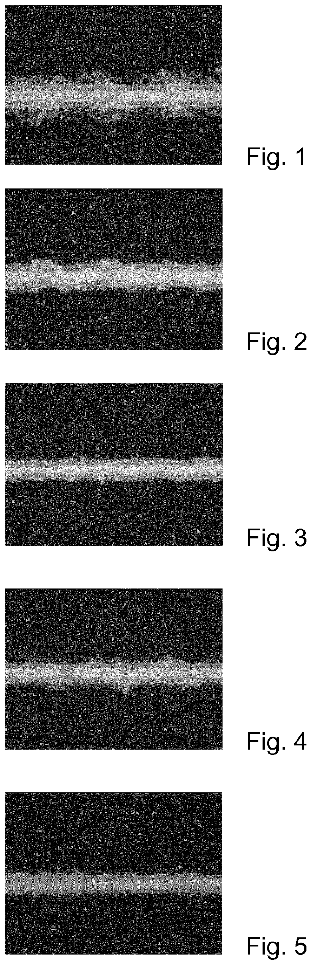

With increasing demand for generating fine lines with high speed printing, the organic medium in the paste composition becomes more sophisticated. As depicted in Figure 1, the printed fine lines typically have a thin layer of irregular shaped region adjacent to the main body of the lines. The film thickness of this irregular shaped region is much thinner than that of the main body of the lines, therefore this region has the disadvantage of much higher electrical resistance and increasing printed line width, causing increased shading of the printed solar cell and reduced cell efficiency. This region is referred as 'seepage'. In high speed screen printing, it is desired to generate fine lines without line interruptions and without seepage.

Typical compositions for electrically conductive pastes are disclosed for example in US 2014/0124713 A1, US-A 2012/0164777, WO-A 2011/055995, WO-A 2009/157727, or US 6,156,237. However, all of the known pastes have the disadvantage that it can not be excluded that the printed lines have undesired interruptions or have seepage at the edges and thus are wider than design acceptability, when used in high speed screen printing with designed line width narrower than 40 µm. Therefore, it has been an objective of the present invention to provide a conductive paste which can be processed by high speed screen printing and where the printed lines are narrow without seepage at the edges and have no undesired interruptions.

This objective is solved by a conductive paste, comprising from 50 to 97 wt% of electrically conductive particles, 3 to 50 wt% of an organic medium and 0 to 20 wt% of a glass frit, the organic medium comprising a solvent, wherein the organic medium additionally comprises 10 to 90 wt% of a hydrocarbon-based lubricating oil and 2 to 60 wt% of a polymeric component, each based on the total amount of the organic medium, the polymeric component having a solubility of at least 100 g/kg in the lubricating oil.

Surprisingly it has been shown that the addition of a hydrocarbon-based lubricating oil and a polymeric component having a solubility of at least 100 g/kg improved performance of the conductive paste in high speed screen printing. In comparison to known compositions, the inventive conductive paste has two advantages. Firstly, it can print narrower lines and without seepage at edges. Secondly, the paste allows the use of screens with finer finger-opening with lower tendency to line interruptions. This results in reduced line resistance of the circuits and less metal consumptions. In the application of solar cells, less seepage reduces the shadowing to the semiconductor surfaces, thus increases cell efficiencies.

The polymeric component which is dissolved in the hydrocarbon-based lubricating oil preferably is a polyacrylate, a polymethacrylate, a copolymer of polyacrylate or polymethacrylate, or a mixture thereof.

In a particularly preferred embodiment, the polymeric component is a polymethacrylate with the general formula 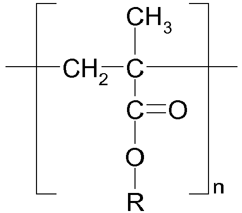 in which n is a whole number and R is a linear or branched C₁- to C₂₂-alkyl.

In general, the (meth)acrylic acid esters employed to build up the polymer are methyl, ethyl, n-propyl, i-propyl, n-butyl, i-butyl, sec-butyl, tert-butyl, pentyl, hexyl, heptyl, octyl, 2-ethylhexyl, 2-propyl heptyl, nonyl, decyl, stearyl, lauryl, octadecyl, heptadecyl, nonadecyl, eicosyl, henicosyl, docosyl, tricosyl, tetracosyl, pentacosyl, hexacosyl, heptacosyl, octacosyl, nonacosyl, triacontyl, behenyl methacrylate or acrylate, preferably lauryl, heptadecyl and stearyl, or mixtures of these monomers. The preferred polymers are copolymers of polymethacrylates with R being methyl and one or more selected from C₅ - to C₂₂-alkyl.

The use of hydroxyl-, epoxy- and amino-functional methacrylates and acrylates is also possible.

The acrylates and methacrylates and mixtures thereof are generally employed in amounts in the range from 50 to 100 wt%, preferably from 80 to100 wt%, based on the total amount of monomers of component.

As further comonomers, up to 50 wt%, preferably up to 20 wt%, of the following monomers, which are listed by way of example, can be employed: vinylaromatic compounds, such as styrene, alpha-methylstyrene, vinyltoluene or p-(tert-butyl) styrene; acrylic and methacrylic acid; acrylamide and methacrylamide; maleic acid and the imides and C₁-C₁₀-alkyl esters thereof; fumaric acid and the imides and C₁-C₁₀-alkyl esters thereof; itaconic acid and the imides and C₁-C₁₀-alkyl esters thereof; acrylonitrile and methacrylonitrile.

Conventional methods of free-radical polymerization can be used to prepare the copolymers of the polymethacrylate used for the conductive paste of the present invention. Polymerization of the alkyl methacrylate monomers can take place under a variety of conditions, including bulk polymerization, solution polymerization, usually in an organic solvent.

In the solution polymerization, the reaction mixture comprises a diluent, the alkyl(meth)acrylate monomers, a polymerization initiator and usually a chain transfer agent and optionally a crosslinker.

The copolymers of the polymethacrylate used for the conductive paste of the present invention have a relative weight average molecular weight ranging from about 10,000 g/mol to about 1,000,000 g/mol. Typically the weight average may range from about 20,000 g/mol to about 600,000 g/mol. The molecular weight can be determined for example by GPC using a poly methyl methacrylate standard. The determined average molecular weight is therefore relative to the standard not absolute.

The polymers have a PDI number ranging from 1 to 10, preferably 2 to 8, mostly preferred 2 to 6. PDI stands for polydispersity index, which measures the molecular weight distribution. The PDI is described for example in "S. S. Rane, P. Choi, Chem. Mater. 2005, 17, 926".

The hydrocarbon-based lubricating oil, which is used for the conductive paste preferably is selected from naphthenic oils, paraffinic oils, aromatic oils or a mixture of at least two of them.

Preferred hydrocarbon-based lubricating oils contemplated for use in this invention include mineral oils, poly-alpha-olefin synthetic oils, natural oils such as vegetable or animal based oils and mixtures thereof. Suitable base oils also include oils obtained by isomerization of synthetic wax and slack wax, as well as base stocks produced by hydrocracking (rather than solvent extracting) the aromatic and polar components of the crude oil. In general, both the mineral and synthetic base oils will each have a kinematic viscosity ranging from about 1 to about 40 mm²/s at 100 °C, although typical applications will require each oil to have a viscosity ranging from about 1 to about 10 mm²/s at 100 °C.

The hydrocarbon-based lubricating oils useful in this invention include all common mineral oil base stocks. This would include oils that are naphthenic, paraffinic or aromatic in chemical structure. Naphthenic oils are made up of methylene groups arranged in ring formation with paraffinic side chains attached to the rings. The pour point is generally lower than the pour point for paraffinic oils. Paraffinic oils comprise saturated, straight chain or branched hydrocarbons.

The straight chain paraffins of high molecular weight raise the pour point of oils and are often removed by dewaxing. Aromatic oils are hydrocarbons of closed carbon rings of a semi-unsaturated character and may have attached side chains. This oil is more easily degraded than paraffinic and naphthalenic oils leading to corrosive by-products.

In reality a base stock will normally contain a chemical composition which contains some proportion of all three types (paraffinic, naphthenic and aromatic). For a discussion of types of base stocks, see for example "Motor Oils and Engine Lubricating by A. Schilling, Scientific Publications, 1968, section 2.2 to 2.5".

The polymeric component may be used in paraffinic, naphthenic and aromatic type oils. For example, the polymeric component may be used in groups I-V base oils according to API base stock categories. These groups are well known by those skilled in the art. Additionally, the polymeric component may be used in gas to liquid oils.

Gas to liquid oils (GTL) are well known in the art. Gaseous sources include a wide variety of materials such as natural gas, methane, C₁-C₃ alkanes, landfill gases, and the like. Such gases may be converted to liquid hydrocarbon products suitable for use as lubricant base oils by a gas to liquid (GTL) process, such as the process described in US 6,497,812.

Oils may be refined by conventional methodology using acid, alkali, and clay or other agents such as aluminum chloride, or they may be extracted oils produced, for example, by solvent extraction with solvents such as phenol, sulfur dioxide, furfural, dichlor-diethyl ether, etc. They may be hydrotreated or hydrorefined, dewaxed by chilling or catalytic dewaxing processes, or hydrocracked. The mineral oil may be produced from natural crude sources or be composed of isomerized wax materials or residues of other refining processes. The preferred synthetic oils are oligomers of α-olefins, particularly oligomers of 1-decene, also known as poly-alphaolefins or PAOs.

The mineral oils may be derived from refined, re-refined oils, or mixtures thereof. Unrefined oils are obtained directly from a natural source or synthetic source (e.g., coal, shale, or tar sands bitumen) without further purification or treatment. Examples of unrefined oils include a shale oil obtained directly from a retorting operation, a petroleum oil obtained directly from distillation, or an ester oil obtained directly from an esterification process, each of which is then used without further treatment. Refined oils are similar to the unrefined oils except that refined oils have been treated in one or more purification steps to improve one or more properties. Suitable purification techniques include distillation, hydrotreating, dewaxing, solvent extraction, acid or base extraction, filtration, and percolation, all of which are known to those skilled in the art. Re-refined oils are obtained by treating used oils in processes similar to those used to obtain the refined oils. These re-refined oils are also known as reclaimed or reprocessed oils and are often additionally processed by techniques for removal of spent additives and oils breakdown products.

The electrically conductive particles present in the electrically conductive paste may be particles of any geometry composed of any electrically conductive material. Preferably, the electrically conductive particles comprise carbon, silver, gold, aluminum, platinum, palladium, tin, nickel, cadmium, gallium, indium, copper, zinc, iron, bismuth, cobalt, manganese, molybdenum, chromium, vanadium, titanium, tungsten, or mixtures or alloys thereof or are in the form of core-shell structures thereof. Preferred as material for the electrically conductive particles are silver or aluminum, particularly silver due to good conductivity and good oxidation resistance.

The mean particle size of the electrically conductive particles preferably is in the range from 10 nm to 100 µm.More preferably, the mean particle size is in the range from 100 nm to 50 µm and particularly preferred, the mean particle size is in the range from 500 nm to 10 µm.The electrically conductive particles may have any desired form known to those skilled in the art. For example, the particles may be in the form of flakes, rods, wires, nodules, spheres or any mixtures thereof. Spherical particles in context of the present invention also comprise particles with a real form which deviates from the ideal spherical form. For example, spherical particles, as a result of the production, may also have a droplet shape or be truncated. Suitable particles which can be used to produce the conductive paste are known to those skilled in the art and are commercially available. Particularly preferably, spherical silver particles are used. The advantage of the spherical particles is their improved rheological behavior compared to irregular shaped particles.

The proportion of electrically conductive particles in the composition is in the range from 50 to 97 % by weight. The proportion is preferably in the range from 70 to 95 % by weight and particularly in the range from 85 to 92 % by weight. This weight percentage of solid particles is often referred as solids content.

The particles shapes and sizes do not change the nature of this invention. Particles can be used as mixtures of different shapes and sizes. It is known to those skilled in the art that the particles with mixtures of different shapes or sizes can result in higher or lower viscosity when they are dispersed in the same organic medium. In such case, it is known to those skilled in the art that the organic medium needs to be adjusted accordingly. The adjustment can be but is not limited to variations of solids content, solvent content, polymer content, thixotrope content and/or surfactant content. As an example, typically when nano-sized particles are used to replace microsized particles, the solids content has to be reduced to avoid an increase of the viscosity of the paste, which results in higher contents of organic components.

The electrically conductive particles, especially when made of a metal, generally are coated with organic additives in the course of production. In the course of preparation of the composition for printing conductor tracks, the organic additives on the surface are typically not removed, such that they are then also present in the conductive paste. The proportion of additives for stabilization is generally not more than 10 % by weight, based on the mass of particles. The additives used to coat the electrically conductive particles may, for example, be fatty amines or fatty amides, for example dodecylamine. Further additives suitable for stabilizing the particles are, for example, octylamine, decylamine, and polyethyleneimines. Another embodiment may be fatty acids, fatty acid esters, with or without epoxylation, for example, lauric acid, palmitic acid, oleic acid, stearic acid, or a salt thereof. The coating on the particles does not change the nature of this invention.

In an embodiment, the conductive paste additionally comprises a glass frit. If a glass frit is present in the paste, any glass frit known to a skilled person can be used, either based on lead-containing compositions or on lead-free compositions. The glass frit is not bound to any particular shape or form. The mean particle size of the particles of the glass frit used is in the range from 10 nm to 100 µm.The mean particle size of the glass frit particles is more preferably in the range from 100 nm to 50 µm and particularly preferred in the range from 500 nm to 10 µm. The particles used may have any desired form known to those skilled in the art. For example, the particles may be in the form of flakes, rods, wires, nodules, spheres or any mixture thereof. Spherical particles in this context mean that the real form of the particles deviates from the ideal spherical form, for example, spherical particles, as a result of the production, may also have a droplet shape or be truncated. Suitable particles which can be used as glass frit are known to those skilled in the art and are commercially available. Especially preferred, spherical particles are used. The advantage of spherical particles is their improved rheological behavior compared to irregular shaped particles. According to the invention, the glass frit content is in the range from 0 to 20 % by weight, preferably from 0 to 10 % by weight and most preferably from 1 to 5 % by weight, based on the total mass of the conductive paste.

The organic medium in the conductive paste comprises at least one solvent. In one embodiment of the invention, the solvent comprises one or more solvents selected from liquid organic components having at least one oxygen atom. The liquid organic component having at least one oxygen atom is selected from alcohol, ester alcohol, glycol, glycol ether, ketone, fatty acid ester or terpene derivatives, excluding dibasic esters. The liquid organic component for example may be benzyl alcohol, texanol, ethyl lactate, diethylene glycol monoethyl acetate, diethylene glycol monobutylether, diethylene glycol dibutylether, diethylene glycol monobutylether acetate, butyl cellosolve, butyl cellosolve acetate, propylene glycol monometylether, propylene glycol monomethylether acetate, dipropylene glycol monomethylether, propylene glycol monomethylpropionate, ethylether propionate, dimethylamino formaldehyde, methylethylketone, gamma-butyrolactone, ethyl linoleate, ethyl linolenate, ethyl myristate, ethyl oleate, methyl myristate, methyl linoleate, methyl linolenate, methyl oleate, dibutyl phthalate, dioctyl phthalate and terpineol.

The solvent being a liquid organic component having at least one oxygen atom can be used in the conductive paste either as single solvent or as a solvent mix. In case a solvent mix is used, the solvent additionally comprises 5 to 50 wt% of at least one dibasic ester based on the total mass of the solvent mixture. The dibasic ester preferably is selected from dimethyl esters of adipic acid, glutaric acid, succinic acid or mixtures thereof.

When either a single solvent or a solvent mixture is used, it is necessary that organic binders can be dissolved greater than 2 wt% in the selected single or mixed solvents, such that the organic medium comprises at least 2% dissolved binder based on the total mass of the organic medium.

In an embodiment of the invention, the paste additionally comprises from 0.1 to 20 wt% of at least one additive selected from surfactants, thixotropic agents, plasticizers, solubilizers, defoamers, desiccants, crosslinkers, complexing agents and/or conductive polymer particles. The additives may be used individually or as a mixture of two or more of them.

When a surfactant is used as an additive, it is possible to use only one surfactant or more than one surfactant. In principle, all surfactants which are known to those skilled in the art or are described in the prior art, can be suitable. Preferred surfactants are singular or plural compounds, for example anionic, cationic, amphoteric or nonionic surfactants. However, it is also possible to use polymers with pigment-affinitive anchor groups, which are known to a skilled person as surfactants.

In case the electrically conductive particles are pre-coated with a surfactant, the conductive paste may not comprise an additional surfactant as additive.

Besides the solvent and the further organic additives, the conductive paste also may comprise organic binders in a range from 0.1 to 20 % by weight. The organic binder can be selected from natural or synthetic resins and polymers. As known to those skilled in the art, selections are based on but not limited to solvent compatibility and chemical stability. For example, the common binders as disclosed in the prior art comprise cellulose derivatives, acrylic resin, phenolic resin, urea-formaldehyde resin, alkyd resin, aliphatic petroleum resin, melamine formaldehyde resin, rosin, polyethylene, polypropylene, polystyrene, polyether, polyurethane, polyvinyl acetate and copolymers thereof.

The inventive paste is particularly usable in high speed screen printing processes, for example, at at least 150 mm/s, as the paste even in these processes results in fine printed lines without line interruptions and seepage.

The invention further relates to a semiconductor device comprising a semiconductor substrate with at least one surface onto which an electrically conductive pattern is printed by using a paste as described above. The pattern thereby is printed onto the semiconductor substrate by screen printing. After printing the semiconductor substrate with the printed pattern is heated to a temperature in the range from 150 °C to 950 °C to form the semiconductor device. The heating process corresponds to that for pastes as already used for producing conductive pattern on semiconductors. Semiconductor substrates usually are based on silicon materials.

Such semiconductor devices include for example photovoltaic cells comprising an n-type region, a p-type region, a p-n junction and conductive gridlines. Photovoltaic cells comprise optionally an anti-reflection layer on the surface of substrate. The substrate can be mono-crystalline silicon, multi-crystalline silicon, amorphous silicon coated solid substrate, or a substrate whose surface is coated with polycrystalline or amorphous transparent conductive oxides (TCO), such as indium tin oxide (ITO), ZnO based transparent conductive oxides, such as indium gallium zinc oxide (IGZO), indium zinc tin oxide (IZTO), indium zinc oxide (IZO), indium tungsten oxide (IWO), gallium zinc oxide (GZO). The conductive gridlines are formed by screen printing from a conductive paste. One or more of the embodiments of the conductive pastes disclosed herein can be used to form the conductive gridlines.

### Examples

In the examples, paste compositions according to the following table have been used:

**Table 1: Compositions of the pastes of the comparative example and the examples**

| | Comparative | Examples 1-4 | Example 5 | Example 6 |
|---|---|---|---|---|
| | Weight % | Weight % | Weight % | Weight % |
| Ag powder | 88.3 | 88.3 | 88.5 | 88.5 |
| Glass frit | 2.5 | 2.5 | 2.5 | 2.5 |
| Surfactant | 0.3 | 0.3 | 0.3 | 0.3 |
| Thixotrope | 0.1 | 0.1 | 0.1 | 0.1 |
| Thickener | 0.1 | 0.1 | 0.1 | 0.1 |
| Ethyl cellulose | 0.2 | 0.2 | 0.2 | 0.2 |
| Solvent Type A | 2.1 | 1.5 | 1.7 | 1.7 |
| Solvent Type B | 5.4 | 4.1 | 4.1 | 4.1 |
| Hydrocarbon oil with 20 to 50 carbon atoms | -- | 1.9 | 2.1 | 2.1 |
| Organic binders | 1 | -- | -- | -- |
| polymeric component in oil | -- | 1 | 0.4 | 0.4 |
| Sum | 100 | 100 | 100 | 100 |

The silver powder used had a mean particle diameter of 0.5 µm to 2.5 µm. As glass frit, a leaded frit has been used. Solvent type A is a dibasic ester and Solvent type B is a mixture of a glycol, a glycol ether and a fatty acid ester.

The polymeric component is a polymethacrylate of the general formula

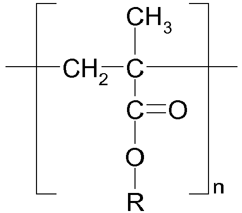

In the examples copolymers of different polymethacrylates with different alkyls as group R have been used. In the following the polymethacrylates are described in the form CxMA, where Cx is the number of carbon atoms in the group R. C1MA for example is a polymethacrylate with methyl as R and C12MA is a poylmethacrylate with C₁₂H₂₅ as R. The amount of the different polymethacrylates in the polymeric component is in % by weight based on the total mass of the polymeric component. All other percentage data is based on the total mass of the paste.

### Comparative Example:

1 % to 3 % of solvent type A and 3.5 % to 6 % of solvent type B are mixed first. 0.05 % to 0.4 % by weight ethyl cellulose is dissolved in this solvent mixture to form the ethyl cellulose medium, which is mixed further with 0.2 % to 2 % polyisobutyl methacrylate (organic binder), 0 to 2 % surfactant, 0 to 1 % thickner, 0 to 1 % thixotrope have been added to form a uniform medium. All percentage values are wt% based on total amount of paste. The mixture has been homogenized by mechanical stirring and elevated temperature. Glass frit and metal powders are added to the medium in an incremental step to ensure that they are well dispersed in the medium. The powder-medium mixture is milled with triple-roll-mill to get a uniformly dispersed paste.

To compare Examples 1 to 6 with the Comparative Example, same silver powder, glass frit, surfactant, thickener, thixotrope and ethyl cellulose are used.

### Example 1:

The paste is prepared following the same procedures as in the Comparative Example, except that no organic binder is added, and instead, polymeric component with lubricating oil are added. The concentration of the mixture of solvents type A and type B is reduced accordingly to keep the same amount of organic liquid in the paste. In this example, the polymeric component is a copolymer of 25 % C1MA + 40 % C12MA + 35 % C17MA, with a molecular weight M_{w} of 127,000 g/mol and PDI = 4.6.

### Example 2:

The paste is prepared following the same procedures as in the Comparative Example, except that no organic binder is added, and instead, polymeric component with petroleum oil are added. The concentration of the mixture of solvents type A and type B is reduced accordingly to keep the same amount of organic liquid in the paste. In this example, the polymeric component is a copolymer of 25 % C1MA + 75 % C18MA with Mw of 57,100 g/mol, PDI = 3.9.

### Example 3:

The paste is prepared following the same procedures as in the Comparative Example, except that no organic binder is added, and instead, polymeric component with petroleum oil are added. The concentration of the mixture of solvents type A and type B is reduced accordingly to keep the same amount of organic liquid in the paste. In this example, the polymeric component is a copolymer of 25 % C1MA + 75 % C18MA with Mw of 28,000 g/mol, PDI = 2.9.

### Example 4:

The paste is prepared following the same procedures as in the Comparative Example. In this example, the polymeric component is a copolymer of 25 % C1MA + 75 % C18MA with Mw of 21,000 g/mol, PDI = 2.7. The slightly difference of the polymeric component does not generate any measurable difference in printability when compared to Example 3.

### Example 5:

The paste is prepared following the same procedures as in the Comparative Example. In this example, the polymeric component is a copolymer of 25 % C1MA + 20 % C17MA + 55 % C18MA with Mw of 529,000 g/mol, PDI = 3.4. In this case, the polymeric component generates higher viscosity than the organic binder solution in the Comparative Example, therefore to the knowledge of a person skilled in the art, polymeric component concentration is adjusted slightly, but still in the range defined by Comparative Example. The printed result has less seepage than Comparative Example.

### Example 6:

The paste is prepared following the same procedures as in the Comparative Example. In this example, the polymeric component is 100 % C18MA with Mw of 936,000 g/mol, PDI = 7.1. In this case, the polymeric component generates higher viscosity than the organic binder solution in the Comparative Example, therefore to the knowledge of a person skilled in the art, polymeric component concentration is adjusted slightly, but still in the range defined by Comparative Example.

The pastes of the comparative example and examples 1 to 3 are screen printed onto solid substrates with the following printing conditions.

### Printing conditions:

| print speed [mm/s] | flood speed [mm/s] | pressure [N] | snap off [mm] |
|---|---|---|---|
| 180 | 300 | 100 | 2.0 |

### Screen parameters:

Comparative Example and Example 1 are printed with Screen A.

| Mesh-count | Finger-opening | EOM | Tension | Angle | Thread diameter | Fabric thickness |
|---|---|---|---|---|---|---|
| 325 | 37 µm | 12 µm | 24 N | 30 ° | 16 µm | 28 µm |

Example 1-3 are printed with Screen B.

| Mesh-count | Finger-opening | EOM | Tension | Angle | Thread diameter | Fabric thickness |
|---|---|---|---|---|---|---|
| 325 | 30 µm | 12 µm | 24 N | 30 ° | 16 µm | 28 µm |

The printed lines are examined under an optical 3D microscope for line dimension evaluations. The results are shown in figures 1 to 5.

### In the figures,

Figure 1 shows the printed line of the comparative example with Screen A,
Figure 2 shows the printed line of Example 1 with Screen A,
Figure 3 shows the printed line of Example 1 with screen B
Figure 4 shows the printed line of Example 2 with Screen B and
Figure 5 shows the printed line of Example 3 with Screen B.

It can be seen in the figures, that the line printed with the paste according to the comparative example is wider than those printed with pastes according to the invention. Further, the seepage of the lines printed with pastes according to the invention are significantly reduced, thus a narrower line width. The line height variations are reduced as well. All the prints do not show line interruptions. Therefore, it is clearly demonstrated the Examples generating better printing results than the Comparative Example.

## Claims

1. A conductive paste, comprising from 50 to 97 wt% of electrically conductive particles, 3 to 50 wt% of an organic medium and 0 to 20 wt% of a glass frit, the organic medium comprising a solvent, wherein the organic medium additionally comprises 10 to 90 wt% of a hydrocarbon-based lubricating oil and 2 to 60 wt% of a polymeric component, each based on the total amount of the organic medium, the polymeric component having a solubility of at least 100 g/kg in the lubricating oil.

2. The conductive paste according to claim 1, wherein the polymeric component is a polyacrylate, a polymethacrylate, a copolymer of polyacrylate or polymethacrylate, or a mixture thereof.

3. The conductive paste according to claim 1 or 2, wherein the polymeric component is a polymethacrylate with the general formula 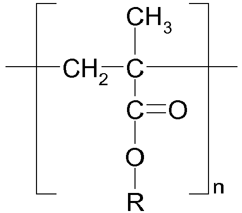 in which n is a whole number and R is a linear or branched C₁- to C₂₂-alkyl.

4. The conductive paste according to any of claims 1 to 4, wherein the polymeric component has a relative weight average molecular weight ranging from about 10,000 g/mol to about 1,000,000 g/mol.

5. The conductive paste according to any of claims 1 to 4, wherein the hydrocarbon-based lubricating oil is selected from naphthenic oils, paraffinic oils, aromatic oils, natural oils or a mixture of at least two of them.

6. The conductive paste according to any of claims 1 to 5, wherein the hydrocarbon-based lubricating oil has a viscosity in the range from 1 to 40 mm²/s at a temperature of 100 °C.

7. The conductive paste according to any of claims 1 to 6, wherein the electrically conductive particles comprise carbon or silver, gold, aluminum, platinum, palladium, tin, nickel, cadmium, gallium, indium, copper, zinc, iron, bismuth, cobalt, manganese, molybdenum, chromium, vanadium, titanium, tungsten, or mixtures or alloys thereof or are in the form of core-shell structures thereof.

8. The conductive paste according to any of claims 1 to 7, wherein the electrically conductive particles are coated with an organic additive.

9. The conductive paste according to any of claims 1 to 8, wherein the solvent comprises one or more solvents selected from liquid organic components having at least one oxygen atom, the liquid organic component having at least one oxygen atom preferably being selected from alcohol, ester alcohol, glycol, glycol ether, ketone, fatty acid ester or terpene derivatives, excluding dibasic esters.

10. The conductive paste according to claim 9, wherein the solvent additionally comprises 5 to 50 wt% of at least one dibasic ester, the dibasic ester preferably being selected from dimethyl esters of adipic acid, glutaric acid, succinic acid or mixtures thereof.

11. The conductive paste according to any of claims 1 to 10, wherein the paste additionally comprises from 0.1 to 20 wt% of at least one additive selected from surfactants, thixotropic agents, plasticizers, defoamers, desiccants, crosslinkers, complexing agents and/or conductive polymer particles.

12. A semiconductor device comprising a semiconductor substrate with at least one surface onto which an electrically conductive pattern is printed by using a paste according to any of claims 1 to 11.

13. The semiconductor device according to claim 12, wherein the semiconductor substrate is based on silicon.

14. The semiconductor device according to claim 12 or 13, wherein an anti-reflection layer is formed onto the semiconductor substrate and the electrically conductive pattern is printed onto the anti-reflection layer.

15. The semiconductor device according to any of claims 12 to 14, wherein the semiconductor device is a photovoltaic cell and the electrically conductive patterns have conductive gridlines.

## Patentansprüche

1. Leitfähige Paste, umfassend von 50 bis 97 Gew.-% an elektrisch leitfähigen Partikeln, 3 bis 50 Gew.-% an einem organischen Medium und 0 bis 20 Gew.-% an einer Glasfritte, wobei das organische Medium ein Lösungsmittel umfasst, wobei das organische Medium zusätzlich 10 bis 90 Gew.-% an einem Schmieröl auf Kohlenwasserstoffbasis und 2 bis 60 Gew.-% an einer Polymerkomponente, jeweils bezogen auf die Gesamtmenge des organischen Mediums, umfasst, wobei die Polymerkomponente eine Löslichkeit von wenigstens 100 g/kg in dem Schmieröl aufweist.

2. Leitfähige Paste gemäß Anspruch 1, wobei die Polymerkomponente ein Polyacrylat, ein Polymethacrylat, ein Copolymer von Polyacrylat oder Polymethacrylat oder ein Gemisch davon ist.

3. Leitfähige Paste gemäß Anspruch 1 oder 2, wobei die Polymerkomponente ein Polymethacrylat mit der allgemeinen Formel 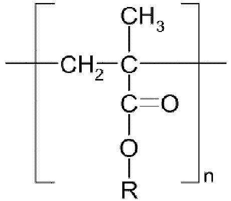 ist, wobei n eine ganze Zahl ist und R ein lineares oder verzweigtes C₁- bis C₂₂-Akyl ist.

4. Leitfähige Paste gemäß einem der Ansprüche 1 bis 4, wobei die Polymerkomponente ein relatives gewichtsgemitteltes Molekulargewicht in dem Bereich von etwa 10.000 g/mol bis etwa 1.000.000 g/mol aufweist.

5. Leitfähige Paste gemäß einem der Ansprüche 1 bis 4, wobei das Schmieröl auf Kohlenwasserstoffbasis ausgewählt ist aus naphthenischen Ölen, paraffinischen Ölen, aromatischen Ölen, natürlichen Ölen und einem Gemisch von wenigstens zwei davon.

6. Leitfähige Paste gemäß einem der Ansprüche 1 bis 5, wobei das Schmieröl auf Kohlenwasserstoffbasis eine Viskosität in dem Bereich von 1 bis 40 mm²/s bei einer Temperatur von 100 °C aufweist.

7. Leitfähige Paste gemäß einem der Ansprüche 1 bis 6, wobei die elektrisch leitfähigen Partikel Kohlenstoff oder Silber, Gold, Aluminium, Platin, Palladium, Zinn, Nickel, Cadmium, Gallium, Indium, Kupfer, Zink, Eisen, Bismut, Cobalt, Mangan, Molybdän, Chrom, Vanadium, Titan, Wolfram oder Gemische oder Legierungen davon umfassen oder in der Form von Kern-Schale-Strukturen davon vorliegen.

8. Leitfähige Paste gemäß einem der Ansprüche 1 bis 7, wobei die elektrisch leitfähigen Partikel mit einem organischen Zusatzstoff beschichtet sind.

9. Leitfähige Paste gemäß einem der Ansprüche 1 bis 8, wobei das Lösungsmittel ein oder mehrere Lösungsmittel ausgewählt aus flüssigen organischen Komponenten mit wenigstens einem Sauerstoffatom umfasst, wobei die flüssige organische Komponente mit wenigstens einem Sauerstoffatom vorzugsweise ausgewählt ist aus Alkohol-, Esteralkohol-, Glycol-, Glycolether-, Keton-, Fettsäureester- oder Terpenderivaten, mit der Ausnahme von zweibasigen Estern.

10. Leitfähige Paste gemäß Anspruch 9, wobei das Lösungsmittel zusätzlich 5 bis 50 Gew.-% an wenigstens einem zweibasigen Ester umfasst, wobei der zweibasige Ester vorzugsweise ausgewählt ist aus Dimethylestern von Adipinsäure, Glutarsäure, Bernsteinsäure und Gemischen davon.

11. Leitfähige Paste gemäß einem der Ansprüche 1 bis 10, wobei die Paste zusätzlich von 0,1 bis 20 Gew.-% an wenigstens einem Zusatzstoff ausgewählt aus grenzflächenaktiven Mitteln, thixotropen Mitteln, Weichmachern, Entschäumern, Trockenmitteln, Vernetzern, Komplexbildnern und/oder leitfähigen Polymerpartikeln umfasst.

12. Halbleitervorrichtung, umfassend ein Halbleitersubstrat mit wenigstens einer Oberfläche, auf die unter Verwendung einer Paste gemäß einem der Ansprüche 1 bis 11 eine elektrisch leitfähige Struktur gedruckt ist.

13. Halbleitervorrichtung gemäß Anspruch 12, wobei das Halbleitersubstrat auf Siliciumbasis ist.

14. Halbleitervorrichtung gemäß Anspruch 12 oder 13, wobei eine Antireflexschicht auf dem Halbleitersubstrat gebildet ist und die elektrisch leitfähige Struktur auf die Antireflexschicht gedruckt ist.

15. Halbleitervorrichtung gemäß einem der Ansprüche 12 bis 14, wobei die Halbleitervorrichtung eine photovoltaische Zelle ist und die elektrisch leitfähigen Strukturen leitfähige Rasterlinien aufweisen.

## Revendications

1. Pâte conductrice, comprenant de 50 à 97 % en poids de particules électroconductrices, 3 à 50 % en poids d'un milieu organique et 0 à 20 % en poids d'une fritte de verre, le milieu organique comprenant un solvant, dans laquelle le milieu organique comprend en outre 10 à 90 % en poids d'une huile lubrifiante à base d'hydrocarbures et 2 à 60 % en poids d'un composant polymère, chacun par rapport à la quantité totale du milieu organique, le composant polymère ayant une solubilité d'au moins 100 g/kg dans l'huile lubrifiante.

2. Pâte conductrice selon la revendication 1, dans laquelle le composant polymère est un polyacrylate, un polyméthacrylate, un copolymère de polyacrylate ou de polyméthacrylate ou un mélange de ceux-ci.

3. Pâte conductrice selon la revendication 1 ou 2, dans laquelle le composant polymère est un polyméthacrylate répondant à la formule générale 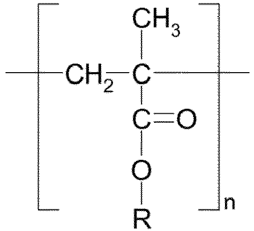 dans laquelle n est un nombre entier et R est un groupe alkyle en C₁ à C₂₂ linéaire ou ramifié.

4. Pâte conductrice selon l'une quelconque des revendications 1 à 4, dans laquelle le composant polymère a une masse moléculaire relative moyenne en poids allant d'environ 10 000 g/mol à environ 1 000 000 g/mol.

5. Pâte conductrice selon l'une quelconque des revendications 1 à 4, dans laquelle l'huile lubrifiante à base d'hydrocarbures est choisie parmi les huiles naphténiques, les huiles paraffiniques, les huiles aromatiques, les huiles naturelles ou un mélange d'au moins deux d'entre elles.

6. Pâte conductrice selon l'une quelconque des revendications 1 à 5, dans laquelle l'huile lubrifiante à base d'hydrocarbures a une viscosité dans la plage de 1 à 40 mm²/s à une température de 100 °C.

7. Pâte conductrice selon l'une quelconque des revendications 1 à 6, dans laquelle les particules électroconductrices comprennent du carbone ou de l'argent, de l'or, de l'aluminium, du platine, du palladium, de l'étain, du nickel, du cadmium, du gallium, de l'indium, du cuivre, du zinc, du fer, du bismuth, du cobalt, du manganèse, du molybdène, du chrome, du vanadium, du titane, du tungstène ou des mélanges ou alliages de ceux-ci ou sont sous la forme de structures à noyau-enveloppe de ceux-ci.

8. Pâte conductrice selon l'une quelconque des revendications 1 à 7, dans laquelle les particules électroconductrices sont revêtues d'un additif organique.

9. Pâte conductrice selon l'une quelconque des revendications 1 à 8, dans laquelle le solvant comprend un ou plusieurs solvants choisis parmi les composants organiques liquides ayant au moins un atome d'oxygène, le composant organique liquide ayant au moins un atome d'oxygène étant de préférence choisi parmi un alcool, un alcool d'ester, un glycol, un éther de glycol, une cétone, un ester d'acide gras ou des dérivés terpéniques, à l'exclusion d'esters dibasiques.

10. Pâte conductrice selon la revendication 9, dans laquelle le solvant comprend en outre 5 à 50 % en poids d'au moins un ester dibasique, l'ester dibasique étant de préférence choisi parmi les esters diméthyliques de l'acide adipique, de l'acide glutarique, de l'acide succinique ou les mélanges de ceux-ci.

11. Pâte conductrice selon l'une quelconque des revendications 1 à 10, la pâte comprenant en outre de 0,1 à 20 % en poids d'au moins un additif choisi parmi les tensioactifs, les agents thixotropiques, les plastifiants, les antimousses, les siccatifs, les agents de réticulation, les agents complexants et/ou les particules de polymère conducteur.

12. Dispositif à semi-conducteur comprenant un substrat en semi-conducteur ayant au moins une surface sur laquelle un motif électroconducteur est imprimé à l'aide d'une pâte selon l'une quelconque des revendications 1 à 11.

13. Dispositif à semi-conducteur selon la revendication 12, dans lequel le substrat en semi-conducteur est à base de silicium.

14. Dispositif à semi-conducteur selon la revendication 12 ou 13, dans lequel une couche antireflet est formée sur le substrat en semi-conducteur et le motif électroconducteur est imprimé sur la couche antireflet.

15. Dispositif à semi-conducteur selon l'une quelconque des revendications 12 à 14, le dispositif à semi-conducteur étant une cellule photovoltaïque et les motifs électroconducteurs ayant des lignes de grille conductrices.
